# EUROPÄISCHE PATENTSCHRIFT

(11) **EP 1 389 336 B1**
(45) Veröffentlichungstag und Bekanntmachung des Hinweises auf die Patenterteilung: **11.04.2007**
(21) Anmeldenummer: 02750932.2
(22) Anmeldetag: 15.05.2002
(51) Int. Cl.: G11C 29/00

(54) **TESTVERFAHREN ZUM TESTEN EINES DATENSPEICHERS**
TEST METHOD FOR TESTING A DATA MEMORY
PROCEDE D'ESSAI SERVANT A TESTER UNE MEMOIRE DE DONNEES

(30) Priorität: 21.05.2001 DE 10124923
(43) Veröffentlichungstag der Anmeldung: 18.02.2004
(73) Patentinhaber: Infineon Technologies AG, 81669 München (DE)
(72) Erfinder: BENEDIX, Alexander, 81739 München (DE); DÜREGGER, Reinhard, 85586 Poing (DE); HERMANN, Robert, 85250 Altomünster (DE); RUF, Wolfgang, 86316 Friedberg (DE)
(74) Vertreter: Charles, Glyndwr
(86) Internationale Anmeldenummer: PCT/EP2002/005358
(87) Internationale Veröffentlichungsnummer: WO 2002/095763

(56) Entgegenhaltungen:
- EP-A- 0 599 524
- DE-A- 4 135 084
- US-A- 5 406 566
- US-A- 5 673 270
- US-A- 6 058 056
- US-A- 6 163 491

## Beschreibung

Die Erfindung betrifft ein Testverfahren zum Testen eines Datenspeichers und einen Datenspeicher mit integrierter Testdatenkompressionsschaltung zum kostengünstigen Testen von schnellen Halbleiterspeichern, insbesondere von DRAM-Speichern, SRAM-Speichern, die mit sehr hohen Arbeitstaktfrequenzen arbeiten.

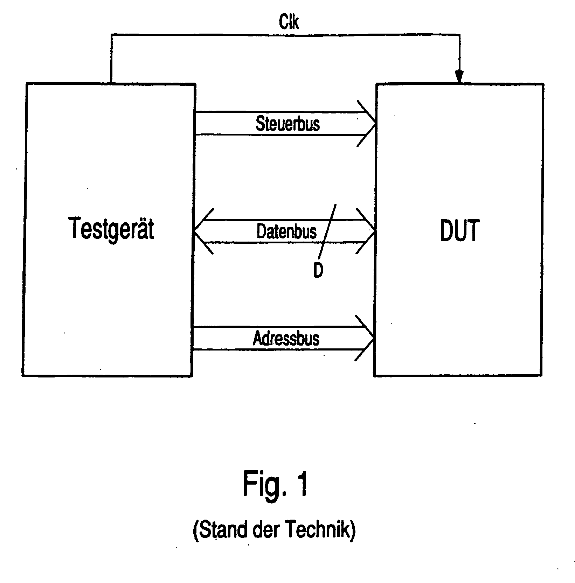

Fig. 1 zeigt eine Testanordnung nach dem Stand der Technik. Eine zu testende Schaltung DUT (DUT: device under test) ist über einen Steuerbus, einen Datenbus und einen Adressbus an ein externes Testgerät angeschlossen. Das externe Testgerät erzeugt in einem Testdatengenerator Testdaten, die über Datenbusleitungen eines Datenbusses an den zu testenden Speicher DUT angelegt werden. Über den Adressbus werden die zu testenden Speicherzellen innerhalb des zu testenden Speichers adressiert. Dabei werden die Testdaten in die adressierten Speicherzellen über den Datenbus eingeschrieben und anschließend wieder ausgelesen. Das externe Testgerät vergleicht die eingeschriebenen Testdaten mit den ausgelesenen Daten und erkennt anhand der Abweichungen bzw. Datenfehler ob die adressierten Speicherzellen innerhalb des Speichers funktionsfähig sind.

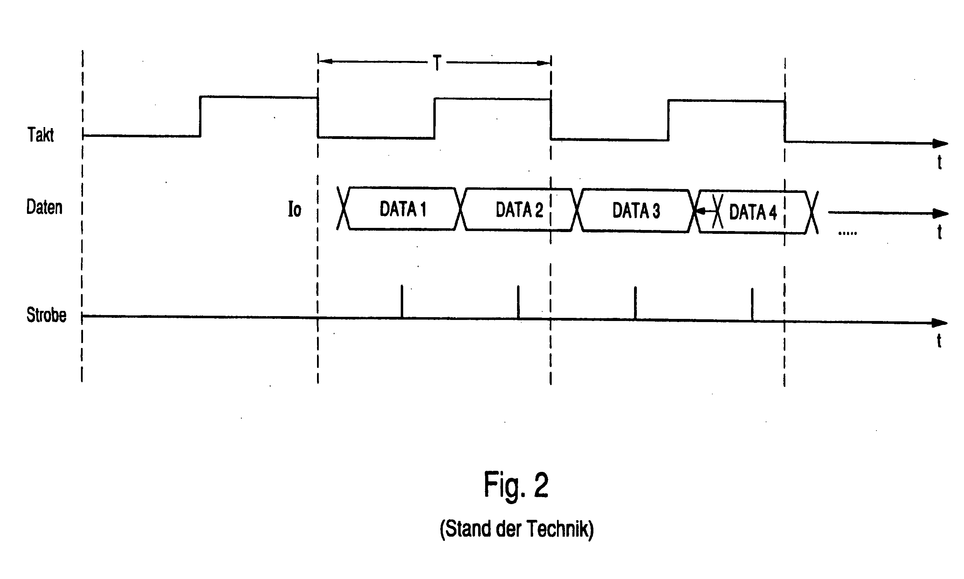

Fig. 2 zeigt Ablaufdiagramme bei der in Fig. 1 dargestellten Testanordnung nach dem Stand der Technik. Das Testgerät überträgt die Testdaten über eine Datenleitung mit einer hohen Taktfrequenz und liest sie anschließend wieder aus dem Datenspeicher aus. Auf jeder Datenleitung des Datenbusses empfängt das Testgerät eine Testdatenfolge, die bei dem in Fig. 2 dargestellten Beispiel aus vier Testdaten besteht. Eine derartige Testdatenfolge wird auch als Datenburst bezeichnet. Das Testgerät erzeugt ein internes Strobe-Signal, wobei bei jedem Strobe-Signal ein empfangenes Testdatum mit einem gespeichertem Referenzdatum innerhalb des Testgeräts verglichen wird, so dass Datenabweichungen ermittelt werden können. Diese Datenabweichungen zeigen an, dass die adressierte Speicherzelle innerhalb des Datenspeichers fehlerhaft ist. Moderne Datenspeicher arbeiten mit immer höheren Arbeitstaktfrequenzen, so dass auch die Datenübertragungsraten, mit denen die Testdaten in die Speicherzellen eingeschrieben und anschließend wieder ausgelesen werden, ebenfalls immer höher werden. Daher muss die Arbeitstaktfrequenz des externen Testgeräts, in der die Auswertung der ausgelesenen Testdaten erfolgt, ebenfalls erhöht werden. Bei dem in Fig. 2 dargestellten Beispiel entspricht die Taktfrequenz des Strobe-Signals der Datenübertragungsrate der ausgelesenen Testdaten. Mit der zunehmenden Datenübertragungsrate des zu testenden Halbleiterspeichers ist es daher bei der in Fig. 1 dargestellten Testanordnung notwendig, dass auch das Testgerät entsprechend angepasst wird. Aufgrund der immer kürzer werdenden Entwicklungszyklen zur Entwicklung von modernen Datenspeichern, die mit immer höheren Datenübertragungsraten arbeiten, können zum Testen entwickelte Datenspeicher die bisher eingesetzten Testgeräte in vielen Fällen nicht mehr eingesetzt werden. Bei sehr hohen Datenübertragungsraten des zu testenden Datenspeichers benötigt man daher Testgeräte, die schaltungstechnisch relativ aufwendig und somit kostenintensiv sind. Das Dokument EP-A-0 599 524 zeigt bekannte Testverfahren und Datenspeicher gemäß der Oberbegriffe der Ansprüche 1 und 6.

Es ist daher die Aufgabe ein Testverfahren zum Testen eines Datenspeichers und einen Datenspeicher zu schaffen, die das Testen eines Datenspeichers, der eine sehr hohe Arbeitstaktfrequenz aufweist, mit einem herkömmlichen Testgerät erlauben, das mit einer geringeren Taktfrequenz arbeitet.

Diese Aufgabe wird erfindungsgemäß durch ein Testverfahren mit den im Patentanspruch 1 angegebenen Merkmalen und durch einen Datenspeicher mit den im Patentanspruch 6 angegebenen Merkmalen gelöst.

Die Erfindung schafft ein Testverfahren zum Testen eines Datenspeichers, bei dem mehrere seriell aus dem Datenspeicher ausgelesene Testdaten einer Testdatenfolge mit ReferenzTestdaten zur Erzeugung eines komprimierten Anzeigedatums verglichen werden, wobei das Anzeigedatum anzeigt, ob in der Testdatenfolge mindestens ein Datenfehler aufgetreten ist.

Die Testdatenfolge besteht dabei vorzugsweise aus einer vorgegebenen Anzahl von Testdatenbits.

Die Testdatenfolge wird vorzugsweise in einem Testdatengenerator eines externen Testgeräts erzeugt und über eine Datenleitung eines Datenbusses in ein Speicherzellenfeld des Datenspeichers eingeschrieben,
wobei die eingeschriebene Testdatenfolge anschließend aus dem Speicherzellenfeld über eine Datenleitung des Datenbusses wieder ausgelesen und durch eine in dem Datenspeicher integrierte Kompressionsschaltung entsprechend einem Kompressionsfaktor zu einem Anzeigedatum komprimiert wird,
wobei das Anzeigedatum über eine zugehörige Anzeigeleitung eines Anzeigedatenbusses von dem Datenspeicher an das externe Testgerät zur Datenauswertung abgegeben wird.

Der Kompressionsfaktor ist vorzugsweise gleich der Anzahl der Testdatenbits einer Testdatenfolge.

Die Testdaten werden vorzugsweise mit einer ersten Datenübertragungsrate von dem externen Testgerät in das Speicherzellenfeld des Datenspeichers eingeschrieben und die Anzeigedaten werden mit einer zweiten Datenübertragungsrate von dem Datenspeicher in das externe Testgerät abgegeben,
wobei das Verhältnis der ersten Datenübertragungsrate zu der zweiten Datenübertragungsrate dem Kompressionsfaktor entspricht.

Bei einer bevorzugten Ausführungsform des erfindungsgemäßen Testverfahrens werden die ausgelesenen Testdaten einer Test-datenfolge in ein Testdaten-Register der Kompressionsschaltung seriell eingeschrieben und mit den Referenzdaten, die in einem Referenzregister der Kompressionsschaltung gespeichert sind, durch eine logische Vergleichsschaltung zur Erzeugung eines Anzeigedatums bitweise verglichen.

Dabei werden die Referenzdaten in das Referenzdatenregister der Kompressionsschaltung in einem Initialisierungsbetriebsmodus durch das externe Testgerät eingeschrieben.

Die Erfindung schafft ferner einen Datenspeicher mit integrierter Testdatenkompressionsschaltung, wobei der Datenspeicher aufweist:
ein Speicherzellenfeld mit einer Vielzahl von adressierbaren Speicherzellen,
Schreib-/Leseverstärker zum Einschreiben und Auslesen von Daten in die Speicherzellen über einen internen Datenbus des Datenspeichers,
und eine Testdatenkompressionsschaltung, die mehrere Testdatenfolgen, die jeweils aus dem Speicherzellenfeld in einem Testbetriebsmodus über eine Datenleitung des internen Datenbusses seriell ausgelesen werden mit gespeicherten Referenz-Testdatenfolgen zur Erzeugung von jeweils einem Anzeigedatum komprimiert, das anzeigt, ob in der ausgelesenen Testdatenfolge mindestens ein Datenfehler aufgetreten ist.

Dabei werden die durch die Testdatenkompressionsschaltung erzeugten Anzeigedaten jeweils über eine Anzeigedatenleitung eines Anzeigedatenbusses von dem Datenspeicher an ein externes Testgerät zur weiteren Datenauswertung übertragen.

Der erfindungsgemäße Datenspeicher enthält vorzugsweise eine steuerbare Schalteinheit, die zwischen einem externen Datenbus zum Datenaustausch mit dem externen Testgerät, dem internen Datenbus zum Datenaustausch mit dem Speicherzellenfeld und der Datenkompressionsschaltung geschaltet ist.

Die steuerbare Schalteinheit ist vorzugsweise über Steuerleitungen durch das externe Testgerät zwischen einem normalen Betriebsmodus und einem Testbetriebsmodus umschaltbar,
wobei in dem Testbetriebsmodus die über eine Datenleitung des internen Datenbusses ausgelesenen Testdaten einer Testdatenfolge durch die Schalteinheit über eine Datenleitung eines internen Testdatenbusses in ein Testdatenregister der Testdatenkompressionsschaltung seriell eingeschrieben werden.

Der externe Datenbus, der interne Datenbus, der Testdatenbus und der Anzeigedatenbus weisen vorzugsweise die gleiche Busbreite auf.

Bei einer besonders bevorzugten Ausführungsform des erfindungsgemäßen Datenspeichers enthält die Testdatenkompressionsschaltung mehrere Testdatenkompressionsschaltungsmodule, die jeweils ein Testdatenregister zum Speichern einer über eine Datenleitung des Testdatenbusses aus dem Speicherfeld ausgelesenen Testdatenfolge;
ein Referenzdatenregister zum Speichern einer Referenztestdatenfolge, und
eine logische Vergleichsschaltung aufweisen, die die gespeicherte Testdatenfolge mit der gespeicherten Referenztestdatenfolge zur Erzeugung eines Anzeigedatums vergleichen.

Bei der logischen Vergleichsschaltung handelt es sich vorzugsweise um eine XOR-Logikschaltung.

Im weiteren wird eine bevorzugte Ausführungsform des erfindungsgemäßen Testverfahrens und des erfindungsgemäßen Datenspeichers zur Erläuterung erfindungswesentlicher Merkmale unter Bezugnahme auf die beigefügten Figuren beschrieben.

Es zeigen:
Fig. 1 eine Testanordnung nach dem Stand der Technik;
Fig. 2 ein Ablaufdiagramm zur Erläuterung der der Erfindung zugrundeliegenden Problematik;
Fig. 3 ein Blockschaltbild einer bevorzugten Ausführungsform des erfindungsgemäßen Datenspeichers;
Fig. 4 ein Blockschaltbild einer in dem erfindungsgemäßen Datenspeicher enthaltenen Testdaten-Kompressionsschaltung mit mehreren Testdaten-Kompressionsschaltungsmodulen;
Fig. 5 ein Blockschaltbild eines Testdaten-Kompressionsschaltungsmoduls innerhalb der in Fig. 4 dargestellten Testdaten-Kompressionsschaltung;
Fig. 6 ein Ablaufdiagramm von Testsignalen beim Ablauf des erfindungsgemäßen Testverfahrens.

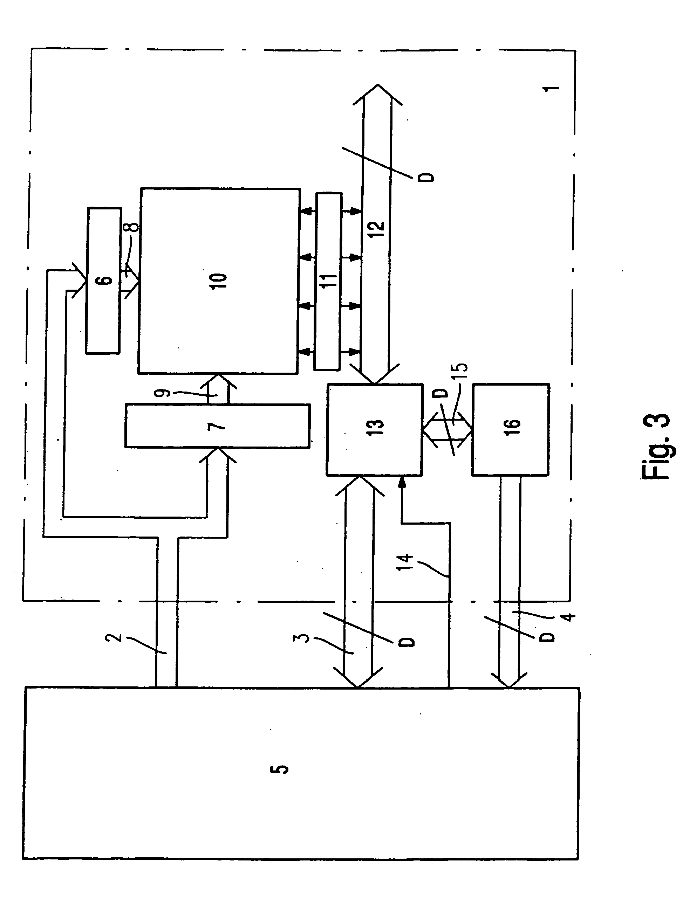

Fig. 3 zeigt ein Blockschaltbild eines erfindungsgemäßen Datenspeichers 1, der über einen Adressbus 2, einen externen Datenbus 3 und einen Anzeigedatenbus 4 mit einem externen Testgerät 5 verbunden ist. Der Adressbus 2 ist an einen Spaltenadressdecoder 6 und einen Zeilenadressdecoder 7 angeschlossen, die die angelegte Adressen decodieren und über Leitungen 8, 9 Speicherzellen innerhalb eines Speicherzellenfeldes 10 aktivieren. Das Speicherzellenfeld 10 ist über Schreib-/Leseverstärker 11 an einen internen Datenbus 12 des Datenspeichers 1 angeschlossen. Zwischen dem externen Datenbus 3 und dem internen Datenbus 12 ist eine steuerbare Schalteinheit 13 vorgesehen, die über Steuerleitungen 14 von dem externen Testgerät 5 ansteuerbar ist. An der Schalteinheit 13 ist über einen internen Testdatenbus 15 eine Testdatenkompressionsschaltung 16 angeschlossen.

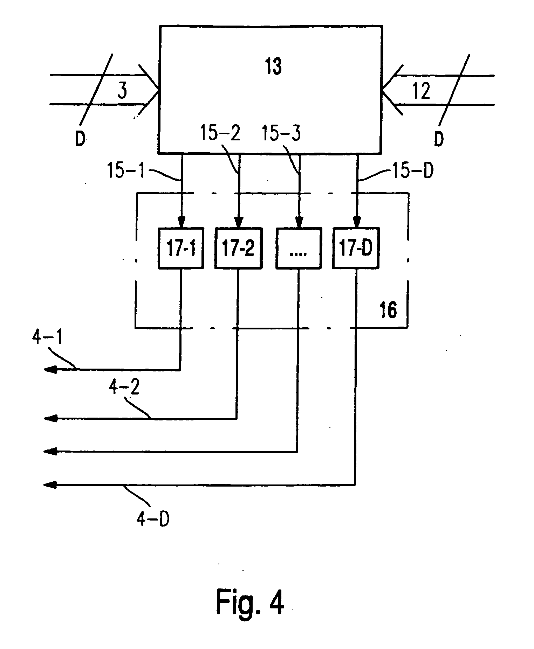

Fig. 4 zeigt ein Blockschaltbild der Testdatenkompressionsschaltung 16. Die Testdatenkompressionsschaltung 16 ist über Datenleitungen 15-i an die Schalteinheit 13 angeschlossen. Die Datenbusbreite des Testdatenbusses 15 zwischen der Schaltungseinheit 13 und der integrierten Testdaten-Kompressionsschaltung 16 entspricht der Datenbusbreite des externen Datenbusses 3 und des internen Datenbusses 12. Die Testdaten-Kompressionsschaltung enthält D TestdatenKompressionsschaltungsmodule 17-i, die jeweils ein Anzeigedatum erzeugen, das über eine Anzeigendatenleitung 4-i an das externe Testgerät 5 zur weiteren Datenauswertung abgegeben wird.

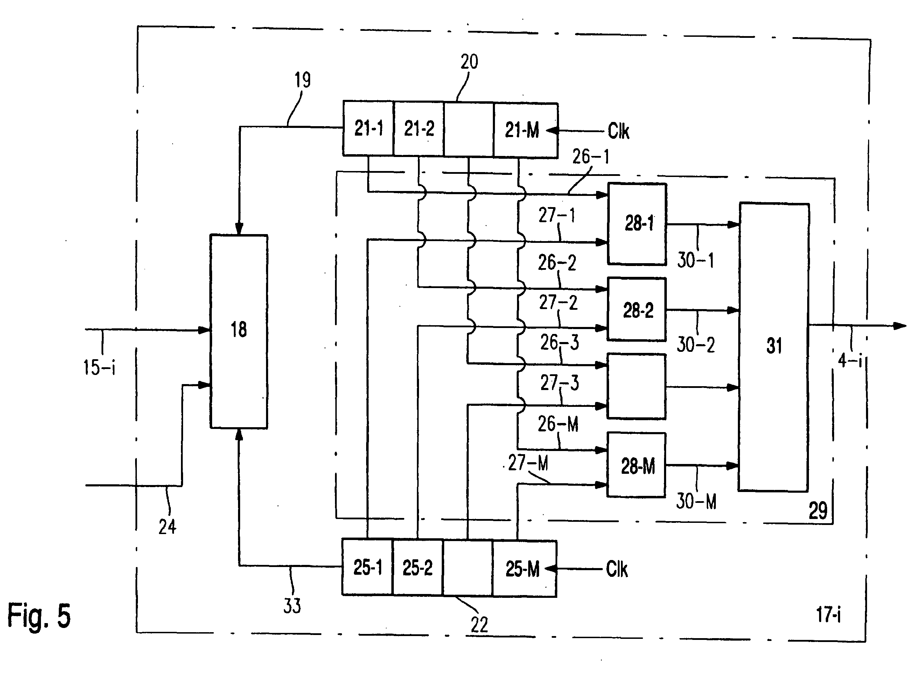

Fig. 5 zeigt den schaltungstechnischen Aufbau eines Testdaten-Kompressionsschaltungsmoduls 17 im Detail. Das Testdaten-Kompressionsschaltungsmodul 17 empfängt über eine Datenleitung des internen Testdatenbusses 15 eine aus dem Speicherzellenfeld 10 ausgelesene Testdatenfolge, die aus mehreren Testdatenbits besteht. Die empfangene Testdatenfolge wird über einen steuerbaren internen Schalter 18 und eine Datenleitung 19 in ein getaktetes Testdatenregister 20 seriell eingeschrieben. Das Testdatenregister enthält für jedes Testdatenbit der Testdatenfolge einen Speicherplatz 21. Die Anzahl M der Speicherplätze 21 entspricht der Anzahl der Testdatenbits innerhalb einer Testdatenfolge bzw. eines Testdatenbursts.

Jedes Testdatenschaltungsmodul 17-i enthält ein getaktetes Referenzdatenregister 22 zum Speichern von Referenztestdaten. Das Referenzdatenregister 22 ist über ein Leitung 23 ebenfalls an den steuerbaren Umschalter 18 angeschlossen, der über eine Steuerleitung 24 von dem externen Testgerät 5 angesteuert wird. Das getaktete Referenzdatenregister 22 enthält mehrere Speicherplätze 25 für Referenzdatenbits. Das Referenzdatenregister 22 speichert M Referenzdatenbits ab, die während einer Initialisierungsphase durch das externe Testgerät 5 in das Referenzdatenregister 22 eingeschrieben werden. Die Speicherplätze 21 innerhalb des Testdatenregisters 20 sind über Leitungen 26 und die Speicherplätze 25 innerhalb des Testdatenregisters 22 sind über Leitungen 27 mit Eingängen von XOR-Gattern 28 einer Datenvergleichsschaltung 29 innerhalb des Datenkompressionsschaltungsmoduls 17 verbunden.

Die XOR-Gatter 28 sind über Leitungen 30 mit einer XOR-Schaltung 31 verbunden, die ausgangsseitig ein Anzeigedatum über eine Anzeigeleitung 4-i des Anzeigedatenbusses 4 an das externe Testgerät 5 abgibt. Die Datenvergleichsschaltung 29 führt einen bitweisen Datenvergleich der in dem Referenzdatenregister 22 enthaltenen Solldaten bzw. Referenzdaten mit den Testdaten der aus dem Speicherzellenfeld 10 ausgelesenen Testdatenfolge durch. Weicht aufgrund einer fehlerhaft hergestellten Speicherzelle ein Testdatenbit der in das Testdatenregister 20 eingeschriebenen Testdatenfolge von dem in dem Referenzdatenregister 22 abgespeicherten zugehörigen Referenzdatenbit ab, wird am Ausgang der Datenvergleichsschaltung 29 ein Anzeigedatum generiert, welches anzeigt, dass in der zwischengespeicherten Testdatenfolge mindestens ein Datenfehler aufgetreten ist.

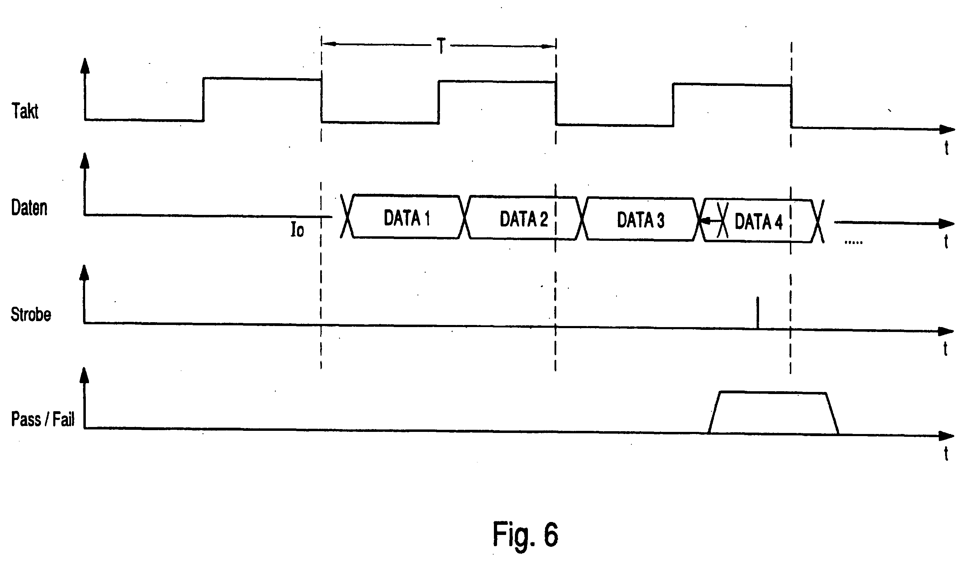

Fig. 6 zeigt Zeitablaufdiagramme während eines Testvorgangs gemäß dem erfindungsgemäßen Testverfahrens zum Testen des in Fig. 3 dargestellten Datenspeichers 1. Aus dem Speicherzellenfeld 10 des Datenspeichers 1 wird eine Testdatenfolge, die bei dem in Fig. 6 dargestellten Beispiel aus vier Testdatenbits besteht, ausgelesen und seriell über eine Datenleitung des internen Datenbusses 12 und des internen Testdatenbusses 15 an ein Testdatenkompressionsschaltungsmodul 17 angelegt und dort in dessen Testdatenregister 20 seriell eingeschrieben. Die Datenvergleichsschaltung 29 generiert ein Anzeigedatum bzw. Pass Fail-Signal, das über eine Anzeigedatenleitung des Anzeigedatenbusses 4 an das externe Testgeräts zur weiteren Datenauswertung abgegeben wird. Die Auswertung des Anzeigedatums durch das externe Testgerät 5 erfolgt mit dem Strobe-Signal.

Wie man durch Vergleich der Figuren 2 und 6 erkennen kann, kann das externe Testgerät 5 bei dem erfindungsgemäßen Testverfahren mit einer Taktfrequenz arbeiten, die um den Datenkompressionsfaktor K niedriger ist als bei der herkömmlichen Testanordnung. Jedes Testdaten-Kompressionsschaltungsmodul 17 innerhalb der Kompressionsschaltung 16 führt eine Testdatenkompression mit einem Testdatenkompressionsfaktur K durch, der der Anzahl der Testdatenbits innerhalb einer Testdatenfolge entspricht. Bei dem in Fig. 6 dargestellten Beispiel beträgt die Testdatenfolge bzw. der Testdatenburst vier Datenbits, die durch ein Testdatenkompressionsschaltungsmodul 17 zu einem Anzeigedatum komprimiert werden, d.h. der Testdatenkompressionsfaktor K beträgt bei dem in Fig. 6 dargestellten Beispiel vier.

Mit dem erfindungsgemäßen Testverfahren ist es möglich, entweder die Testdauer entsprechend dem Testdatenkompressionsfaktor K zu reduzieren oder die in dem externen Testgerät benötigte maximale Arbeitsfrequenz der Dateneingabe und Datenausgabe entsprechend dem Testdatenkompressionsfaktor K zu verringern. Hierdurch ist es möglich bestehende schaltungstechnisch weniger komplexe herkömmliche Testgeräte zum Testen von Datenspeichern einzusetzen, die mit einer sehr hohen Arbeitstaktfrequenz arbeiten.

### Bezugszeichenliste

- 1.: Datenspeicher
- 2.: Adressbus
- 3.: Externer Datenbus
- 4.: Anzeigedatenbus
- 5.: Externes Testgerät
- 6.: Balkenadressdecodierer
- 7.: Reihenadressdecodierer
- 8.: Leitungen
- 9.: Leitungen
- 10.: Speicherzellenfeld
- 11.: Schreib-/Leseverstärker
- 12.: Interner Datenbus
- 13.: Schaltüngseinheit
- 14.: Steuerleitungen
- 15.: Interner Testdatenbus
- 16.: Testdatenkompressionsschaltung
- 17.: Testdatenkompressionsschaltungsmodule
- 18.: Steuerbare Schalteinrichtung
- 19.: Leitung
- 20.: Testdatenregister
- 21.: Testdatenspeicherplätze
- 22.: Referenzdatenregister
- 23.: Leitungen
- 24.: Steuerleitung
- 25.: Referenzdatenspeicherplätze
- 26.: Leitungen
- 27.: Leitungen
- 28.: XOR-Gatter
- 29.: Datenvergleichsschaltung
- 30.: Leitungen
- 31.: XOR-Schaltung

## Patentansprüche

1. Testverfahren zum Testen eines Datenspeichers bei dem mehrere seriell aus dem Datenspeicher (1) ausgelesene Testdaten einer Testdatenfolge mit Referenz-Solldaten zur Erzeugung eines komprimierten Anzeigedatums verglichen werden, **dadurch gekennzeichnet, dass** die ausgelesenen Testdaten der Testdatenfolge in einem Testdatenregister (20) einer Testdaten-Kompressionsschaltung (16) seriell eingeschrieben und mit in einem Initialisierungsbetriebsmodus in einem Referenzdatenregister (22) der Testdaten-Kompressionsschaltung (16) eingeschriebenen Referenz-Solldaten bitweise durch logische Gatter (28) verglichen werden,
wobei eine logische Vergleichsschaltung (31) die Ausgänge der logischen Gatter (28) zu dem komprimierten Anzeigedatum verknüpft, welches anzeigt, ob in der zwischengespeicherten Testdatenfolge mindestens ein Datenfehler aufgetreten ist.

2. Testverfahren nach Anspruch 1,
**dadurch gekennzeichnet, dass**
die Testdatenfolge aus einer vorgegebenen Anzahl (M) von Testdatenbits besteht.

3. Testverfahren nach einem der vorangehenden Ansprüche,
**dadurch gekennzeichnet, dass**
die Testdatenfolge in einem Testdatengenerator eines externen Testgerätes (5) erzeugt wird und über eine Datenleitung eines Datenbusses (3, 12) in ein Speicherzellenfeld (10) des Datenspeichers (1) eingeschrieben wird,
wobei die eingeschriebene Testdatenfolge anschließend aus dem Speicherzellenfeld (10) des Datenspeichers (1) über eine Datenleitung des Datenbusses (12) ausgelesen und durch die in den Datenspeicher (1) integrierte Testdaten-Kompressionsschaltung (16) entsprechend einem Kompressionsfaktor (K) zu dem Anzeigedatum komprimiert wird, das über eine Anzeigedatenleitung eines Anzeigedatenbusses (4) von dem Datenspeicher (1) an das externe Testgerät (5) zur Auswertung abgegeben wird.

4. Testverfahren nach Anspruch 3,
**dadurch gekennzeichnet, dass**
der Kompressionsfaktor (K) gleich der Anzahl (M) von Testdatenbits einer Testdatenfolge ist.

5. Testverfahren nach einem der vorangehenden Ansprüche 3 oder 4,
**dadurch gekennzeichnet , dass**
die Testdaten mit einer ersten Datenübertragungsrate von dem externen Testgerät (5) über den Datenbus (3, 12) in das Speicherzellenfeld (10) des Datenspeichers (1) eingeschrieben werden und die Anzeigedaten mit einer zweiten Datenübertragungsrate von der Datenkompressionsschaltung (16) des Datenspeichers (1) an das externe Testgerät (15) abgegeben werden,
wobei das Verhältnis der ersten Datenübertragungsrate zu der zweiten Datenübertragungsrate dem Kompressionsfaktor (K) entspricht.

6. Datenspeicher mit integrierter Testdaten-Kompressionsschaltung (16), wobei der Datenspeicher (1) aufweist:
(a) ein Speicherzellenfeld (10) mit einer Vielzahl von adressierbaren Speicherzellen;
(b) Schreib/Leseverstärker (12) zum Einschreiben und Auslesen von Daten in die Speicherzellen über einen internen Datenbus (12) des Datenspeichers (1);
(c) und eine Testdaten-Kompressionsschaltung (16) ;
**dadurch gekennzeichnet, dass** die Testdaten-Kompressionsschaltung aufweist :
ein Testdatenregister (20), das zum Speichern von aus dem Speicherzellenfeld (10) ausgelesenen Testdaten einer Testdatenfolge vorgesehen ist;
ein Referenzregister (22), das zum Speichern von Referenz-Solldaten vorgesehen ist, die in einem Initialisierungsbetriebsmodus durch ein externes Testgerät (5) eingeschrieben werden ;
mehrere logische Gattern (28), die die in dem Testdatenregister (20)zwischengespeicherten Testdaten bitweise mit den in dem Referenzregister (22) gespeicherten Referenz-Solldaten vergleichen; und eine logische Vergleichsschaltung (31), die die Ausgänge der logischen Gatter (28) zu einem komprimierten Anzeigedatum verknüpft, welches anzeigt, ob in der zwischengespeicherten Testdatenfolge mindestens ein Datenfehler enthalten ist.

7. Datenspeicher nach Anspruch 6,
**dadurch gekennzeichnet , dass**
durch die Testdaten-Kompressionsschaltung (16) die Anzeigedaten über Anzeigedatenleitungen eines Anzeigedatenbusses (4) an ein externes Testgerät (5) zur Auswertung übertragen werden.

8. Datenspeicher nach Anspruch 6 oder 7,
**dadurch gekennzeichnet , dass**
eine steuerbare Schalteinheit (13) vorgesehen ist, die zwischen einem externen Datenbus (3) zum Datenaustausch mit dem externen Testgerät (5), dem internen Datenbus (12) zum Datenaustausch mit dem Speicherzellenfeld (10) und der Testdaten-Kompressionsschaltung (16) geschaltet ist.

9. Datenspeicher nach Anspruch 8,
**dadurch gekennzeichnet , dass**
die steuerbare Schalteinheit (13) über eine Steuerleitung (14) durch das externe Testgerät (5) zwischen einem normalen Betriebsmodus und einem Testbetriebsmodus umschaltbar ist, wobei in dem Testbetriebsmodus die über eine Datenleitung des internen Datenbusses (12) ausgelesenen Testdaten der Testdatenfolge durch die Schalteinheit (13) in das Testdatenregister (20) der Testdaten-Kompressionsschaltung (16) über eine Datenleitung eines internen Testdatenbusses (15) seriell eingeschrieben werden.

10. Datenspeicher nach einem der vorangehenden Ansprüche 6 bis 9,
**dadurch gekennzeichnet, dass**
die Testdatenfolge eine vorgegebene Anzahl (M) von Testdatenbits aufweist.

11. Datenspeicher nach einem der vorangehenden Ansprüche 6 bis 10,
**dadurch gekennzeichnet , dass**
der externe Datenbus (3), der interne Datenbus (12), der Testdatenbus (15) und der Anzeigedatenbus (4) die gleiche Busbreite aufweisen.

12. Datenspeicher nach einem der vorangehenden Ansprüche 6 bis 11,
**dadurch gekennzeichnet , dass**
die Testdaten-Kompressionsschaltung (16) mehrere Testdatenkompressionsschaltungsmodule (17) enthält, die jeweils
ein Testdatenregister (20) zum Speichern einer über eine Datenleitung des Testdatenbusses (15) aus dem Speicherzellenfeld (10) ausgelesenen Testdatenfolge,
ein Referenzdatenregister (22) zum Speichern einer Referenztestdatenfolge und
eine logische Vergleichsschaltung (29) aufweisen, die die gespeicherte Testdatenfolge mit der gespeicherten Referenztestdatenfolge zur Erzeugung eines Anzeigedatums vergleicht.

## Claims

1. Test method for testing a data store, which involves a plurality of test data in a test data sequence which have been read serially from the data store (1) being compared with reference nominal data in order to produce a compressed indicator data item,
**characterized in that** the test data in the test data sequence which have been read are written serially in a test data register (20) in a test data compression circuit (16) and are compared by logic gates (28) bit by bit with reference nominal data written in a reference data register (22) in the test data compression circuit (16) in an initialization mode of operation,
where a logic comparison circuit (31) logically combines the outputs of the logic gates (28) to form the compressed indicator data item, which indicates whether at least one data error has occurred in the buffer-stored test data sequence.

2. Test method according to Claim 1,
characteized in that
the test data sequence comprises a prescribed number (M) of test data bits.

3. Test method according to one of the preceding claims,
**characterized in that**
the test data sequence is produced in a test data generator in an external test unit (5) and is written to a memory cell array (10) in the data store (1) via a data line in a data bus (3, 12),
with the test data sequence written subsequently being read from the memory cell array (10) in the data store (1) via a data line in the data bus (12) and being compressed by a test data compression circuit (16) integrated in the data store (1) on the basis of a compression factor (K) to form an indicator data item which is sent from the data store (1) to the external test unit (5) via an indicator data line in an indicator data bus (4) for the purpose of evaluation.

4. Test method according to Claim 3,
**characterized in that**
the compression factor (K) is equal to the number (M) of test data bits in a test data sequence.

5. Test method according to one of the preceding Claims 3 or 4,
**characterized in that**
the test data are written to the memory cell array (10) in the data store (1) by the external test unit (5) at a first data transmission rate via the data bus (3, 12) and the indicator data are sent from the data compression circuit (16) in the data store (1) to the external test unit (15) at a second data transmission rate, the ratio of the first data transmission rate to the second data transmission rate corresponding to the compression factor (K).

6. Data store having an integrated test data compression circuit (16), where the data store (1) has:
(a) a memory cell array (10) with a multiplicity of addressable memory cells;
(b) read/write amplifiers (12) for reading and writing data to the memory cells via an internal data bus (12) in the data store (1);
(c) and a test data compression circuit (16); **characterized in that** the test data compression circuit has:
a test data register (20) which is provided for storing test data in a test data sequence which have been read from the memory cell array (10);
a reference register (22) which is provided for storing reference nominal data which are written in by an external test unit (5) in an initialization mode of operation;
a plurality of logic gates (28) which compare the test data buffer-stored in the test data register (20) bit by bit with the reference nominal data stored in the reference register (22); and a logic comparison circuit (31) which logically combines the outputs of the logic gates (28) to form a compressed indicator data item which indicates whether at least one data error is contained in the buffer-stored test data sequence.

7. Data store according to Claim 6,
**characterized in that**
the test data compression circuit (16) transmits the indicator data to an external test unit (5) via indicator data lines in an indicator data bus (4) for the purpose of evaluation.

8. Data store according to Claim 6 or 7,
**characterized in that**
a controllable switching unit (13) is provided which is connected between an external data bus (3) for data interchange with the external test unit (5), the internal data bus (12) for data interchange with the memory cell array (10), and the test data compression circuit (16).

9. Data store according to Claim 8,
**characterized in that**
the controllable switching unit (13) can be changed over by the external test unit (5) between a normal mode of operation and a test mode of operation via a control line (14), with the test data in the test data sequence which have been read via a data line in the internal data bus (12) being written serially to the test data register (20) in the test data compression circuit (16) via a data line in an internal test data bus (15) by the switching unit (13) in the test mode of operation.

10. Data store according to one of the preceding Claims 6 to 9,
**characterized in that**
the test data sequence has a prescribed number (M) of test data bits.

11. Data store according to one of the preceding Claims 6 to 10,
**characterized in that**
the external data bus (3), the internal data bus (12), the test data bus (15) and the indicator data bus (4) have the same bus width.

12. Data store according to one the preceding Claims 6 to 11,
**characterized in that**
the test data compression circuit (16) contains a plurality of test data compression circuit modules (17) which each have a test data register (20) for storing a test data sequence read from the memory cell array (10) via a data line in the test data bus (15),
a reference data register (22) for storing a reference test data sequence, and
a logic comparison circuit (29) which compares the stored test data sequence with the stored reference test data sequence in order to produce an indicator data item.

## Revendications

1. Procédé de test pour tester une mémoire de données dans lequel
plusieurs données de test d'une suite de données de test extraites de la mémoire de données (1) en série sont comparées avec des données théoriques de référence pour générer une donnée de signalisation comprimée, **caractérisé en ce que**
les données de test extraites de la suite de données de test sont enregistrées en série dans un registre de données de test (20) d'un circuit de compression de données de test (16) et sont comparées bit par bit par des portes logiques (28) avec des données théoriques de référence enregistrées, dans un mode de fonctionnement d'initialisation, dans un registre de données de référence (22) du circuit de compression de données de test (16),
un circuit de comparaison (31) logique combine les sorties des portes logiques (28) pour obtenir la donnée de signalisation comprimée, laquelle signale si au moins une erreur de données est apparue dans la suite de données de test mémorisée temporairement.

2. Procédé de test selon la revendication 1,
**caractérisé en ce que**
la suite de données de test est constituée d'un nombre (M) prédéterminé de bits de données de test.

3. Procédé de test selon l'une quelconque des revendications précédentes,
**caractérisé en ce que**
la suite de données de test est générée dans un générateur de données de test d'un appareil de test (5) externe et est enregistrée dans une zone de cellule mémoire (10) de la mémoire de données (1) via une ligne de données d'un bus de données (3, 12),
la suite de données de test enregistrée est ensuite extraite de la zone de cellule mémoire (10) de la mémoire de données (1) via une ligne de données du bus de données (12) et est comprimée en donnée de signalisation par le circuit de compression de données de test (16) intégré dans la mémoire de données (1) en fonction d'un facteur de compression (k), la donnée de signalisation étant délivrée à l'appareil de test externe (5) pour une évaluation, via une ligne de données de signalisation d'un bus de données de signalisation (4) de la mémoire de données (1).

4. Procédé de test selon la revendication 3,
**caractérisé en ce que**
le facteur de compression (K) est identique au nombre (M) de bits de données de test d'une suite de données de test.

5. Procédé de test selon l'une des revendications précédentes 3 ou 4,
**caractérisé en ce que**
les données de test sont enregistrées dans la zone de cellule mémoire (10) de la mémoire de données (1) par l'appareil de test (5) externe, via le bus de données (3, 12), avec un premier taux de transmission de données et les données de signalisation sont délivrées à l'appareil de test externe (15) par le circuit de compression de données (16) de la mémoire de données (1) avec un deuxième taux de transmission de données, le rapport du premier taux de transmission de données sur le deuxième taux de transmission de données correspondant au facteur de compression (K).

6. Mémoire de données avec circuit de compression de données de test intégré (16), la mémoire de données (1) comprenant :
(a) une zone de cellule mémoire (10) avec plusieurs cellules mémoires adressables ;
(b) des amplificateurs d'enregistrement/lecture (12) pour l'enregistrement et la lecture de données dans les cellules mémoire via un bus de données interne (12) de la mémoire de données (1) ;
(c) et un circuit de compression de données de test (16) **caractérisé en ce que** le circuit de compression de données de test comprend :
un registre de données de test (20) prévu pour mémoriser des données de test d'une suite de données de test extraites de la zone de cellule mémoire (10), un registre de référence (22) prévu pour mémoriser des données théoriques de référence qui sont enregistrées dans un mode de fonctionnement d'initialisation par un appareil de test (5) externe ;
plusieurs portes logiques (28) qui comparent bit par bit les données de test mémorisées temporairement dans le registre de données de test (20) avec les données théoriques de référence mémorisées dans le registre de référence (22) ; et
un circuit de comparaison logique (31) qui combine les sorties des portes logiques (28) pour obtenir une donnée de signalisation comprimée laquelle signale si au moins une erreur de données est contenue dans la suite de données de test mémorisée temporairement.

7. Mémoire de données selon la revendication 6,
**caractérisée en ce que**
les données de signalisation sont transmises pour une évaluation à un appareil de test externe (5) par le circuit de compression de données de test (16), via des lignes de données de signalisation d'un bus de données de signalisation (4).

8. Mémoire de données selon la revendication 6 ou 7,
**caractérisée en ce qu'**
on prévoit une unité de commutation (13) pouvant être commandée qui est connectée entre un bus de données externe (3) pour l'échange de données avec l'appareil de test externe (5), le bus de données interne (12) pour l'échange de données avec la zone de cellule mémoire (10) et le circuit de compression de données de test (16).

9. Mémoire de données selon la revendication 8,
**caractérisée en ce que**
l'unité de commutation (13) pouvant être commandée, peut être commutée entre un mode de fonctionnement normal et un mode de fonctionnement de test par l'appareil de test externe (5) via une ligne de commande (14) ;
dans le mode de fonctionnement de test, les données de test de la suite de données de test extraites via une ligne de données du bus de données interne (12) étant enregistrées en série dans le registre de données de test (20) du circuit de compression de données de test (16) par l'unité de commutation (13), via une ligne de données d'un bus de donnes de test (15) interne.

10. Mémoire de données selon l'une des revendications précédentes 6 à 9,
**caractérisée en ce que**
la suite de données de test comprend un nombre (M) prédéterminé de bits de données de test.

11. Mémoire de données selon l'une des revendications précédentes 6 à 10,
**caractérisée en ce que**
le bus de données externe (3), le bus de données interne (12), le bus de données de test (15) et le bus de données de signalisation (4) comportent la même largeur de bus.

12. Mémoire de données selon l'une des revendications précédentes 6 à 11,
**caractérisée en ce que**
le circuit de compression de données de test (16) comprend plusieurs modules de circuit de compression de données de test (17) qui comprennent chacun un registre de données de test (20) pour mémoriser une suite de données de test extraites de la zone de cellule mémoire (10) via une ligne de données du bus de données de test (15),
un registre de données de référence (22) pour mémoriser une suite de données de référence et
un circuit de comparaison logique (29) qui compare la suite de données de test mémorisée avec la suite de données de test de référence pour générer une donnée de signalisation.
